(19)

Europäisches
Patentamt
European
Patent Office
Office européen
des brevets

(11) **EP 2 214 004 A1**

(12) **EUROPEAN PATENT APPLICATION**

(43) Date of publication:
**04.08.2010 Bulletin 2010/31**

(51) Int Cl.:
***G01N 24/10*** (2006.01)  ***G01R 33/60*** (2006.01)

(21) Application number: **10000861.4**

(22) Date of filing: **28.01.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **29.01.2009 PL 38714709**

(71) Applicants:
• **Politechnika Poznañska**
  **61-542 Poznañ (PL)**
• **Jurga, Jan**
  **61-311 Poznañ (PL)**
• **Jurga, Kazimierz**
  **61-606 Poznañ (PL)**

• **Czechowski, Tomasz Jan**
  **61-064 Poznañ (PL)**

(72) Inventors:
• **Politechnika Poznañska**
  **61-542 Poznañ (PL)**
• **Jurga, Jan**
  **61-311 Poznañ (PL)**
• **Jurga, Kazimierz**
  **61-606 Poznañ (PL)**
• **Czechowski, Tomasz Jan**
  **61-064 Poznañ (PL)**

(74) Representative: **Passowicz, Marek**
  **ul. Mielzynskiego 27/29**
  **P.O. Box 85**
  **60-967 Poznan 9 (PL)**

(54) **Method for localization of cancerous and atheromatous lesions by EPRI and a system for applying the method**

(57)    Method for localization of cancerous and atheromatous lesions by EPRI bases on the measurement of the distribution of spin-lattice relaxation times of electron spins in a single projection. The application of multi-component magnetic field to a sample placed in the resonator makes it possible to establish a ratio or any other combination of EPR signal amplitudes recorded in swept conditions, in the presence of a magnetic field gradient, thus obtaining a projection image of relaxation time $T_1$.

A system's source (1) of radio-frequency signals is connected to an input of a signal detection bridge (2) whose input/output is bidirectionally connected to a resonator (4), while an output of the signal detection bridge is connected to a computer (3) whereas one of the computer's outputs is connected to a wave shape generator which (5) is connected to swept coils (6) and the computer's other output is connected to power supply terminals (7,8) of permanent magnetic field coils (9) and gradient coils (10).

Fig. 1

**Description**

The invention relates to a method for localization of cancerous and atheromatous lesions by EPRI and a system for applying the method.

EPR (electron paramagnetic resonance) imaging is capable of providing data about the pharmacokinetics of free radicals and oxygen concentration in body tissues. Tissue oxygen detection represents very important information for cancer treatment in oncology therapy. Since free radicals are only found in tissues in low concentrations and they have a very short life-time, it is assumed that at this stage of study it is necessary to take out a free radical type with an appropriately long life-time and suitable concentration. One of such radical compounds is Lithium phthalocyanine LiPc [1, 2], whose EPR line width is determined to a considerable extent by oxygen concentration in its surroundings. Due to the depth of penetration of electromagnetic radiation into living matter, standard EPR spectrometers operating at microwave frequencies are not useful for EPR imaging. Consequently, lower frequencies from the radio frequency (RF) range are used, which decreases the signal-to-noise (S/N) ratio.

The imaging of small biological objects is currently based on impulse methods [3, 4] and continuous wave (CW) methods [5, 6].

The suitability of pulse methods is limited by very short spin-spin relaxation time ($T_2$) for the majority of radicals. The resultant significant broadening of the width of resonance lines makes these methods unsuitable for EPR imaging. An additional problem is the reduction of relaxation time ($T_2$) resulting from the presence of a field which, at significant gradients, causes free induction decay (FID) during the spectrometer's dead time. The effect makes it more difficult, or even impossible, to perform measurements.

On the other hand, using methods based on the continuous wave (CW) technique is free from such limitations. Standard imaging uses a magnetic field gradient which is constant during swept time. After each measurement, gradient orientation rotates by a fixed angle depending on the number of projections, with the rotation angle changing within the 0°-180° range for 2D imaging. The minimum measurement time for a single projection is 1 ö 2 s, however low signal-to-noise (S/N) ratio in the presence of the gradient requires signal accumulation which, for *in vivo* imaging, extends measurement time to as much as 30 minutes. It should also be noted that the image obtained by the method only represents the spatial distribution of the free radical, without providing any information on its surroundings. Since the EPR method is considerably more sensitive in terms of detecting changes in the local environment of radicals than MRI (magnetic resonance imaging), EPRI is potentially more useful than MRI. To obtain data about the surroundings of the free radical, it is necessary to acquire information not only about the spatial, but also spectral distribution. To this aim, an additional spectral-spatial imaging technique is used for each projection separately [7 - 11]. In practice, this means that measurement time is extended by several times due to the performance of at least a couple of additional measurements for each gradient orientation.

A method making it possible to considerably speed up measurements is Rapid Scan (RS) of the magnetic field [12 - 17]. Instead of second modulation, the method consists of rapid swept of the magnetic field (at a frequency of 1 - 20 kHz), which can be performed in the sinusoidal or triangular pattern. Lack of the second modulation eliminates the need for phase detection, which makes it possible to obtain an absorption spectrum, not its first derivative. Consequently, the measurement time of a single projection can be reduced even to 50 $\mu$s. In practice, spectrum accumulation is required due to low signal-to-noise (S/N) ratio. Despite that, the RS technique has been successfully supplanting the traditional continuous wave (CW) method due to multiple reduction of measurement time.

Recent times have also seen the application of the rotational gradient technique in RS-based imaging [18], which substantially reduces measurement time. The method makes use of gradient rotation during magnetic field swept, whereby the gradient rotation frequency should be at least four times higher than the swept frequency. In practical terms, the limitation causes low swept frequencies (around 1 kHz) to be applied. The limitations outlined above do not occur in the new method for measuring the distribution of spin-lattice relaxation time $T_1$ using a single EPR spectrum, based on the RS technique, which is proposed in the solution described herein.

The object of the present invention is a method for determining the distribution of spin-lattice relaxation time $T_1$ in ERP imaging on the basis of single projections.

The object of the invention is also a device for applying the method, which employs the traditional EPR technique together with modified components operating in the radio frequency range and supporting quadrature detection with Rapid Scan (RS).

The essence of the method according to the present invention is that the application of multi-component magnetic field to a sample placed in the resonator makes it possible to establish a ratio or any other combination of EPR signal amplitudes recorded in swept conditions, in the presence of a magnetic field gradient, thus obtaining a projection image of relaxation time $T_1$.

It is advantageous when the multi-component magnetic field is constituted by a constant external magnetic field, a gradient field and a swept magnetic field (with a sinusoidal or triangular pattern), changing over time T.

Moreover, it is advantageous when the EPR signal amplitude ratio is established at the frequency of source equal to the resonance frequency of the resonator.

It is also advantageous when the EPR signal amplitude ratio is established at the frequency of source different from the resonance frequency of the resonator.

It is advantageous when the EPR signal, defined as the spectrum absorption signal, is obtained by the RS EPR method.

It is furthermore advantageous when the EPR signal, defined as the spectrum dispersion signal, is obtained by the RS EPR method.

Moreover, it is advantageous when the EPR signal, defined as the spectrum absorption signal, is obtained following the deconvolution of data.

It is also advantageous when the EPR signal, defined as the spectrum dispersion signal, is obtained following the deconvolution of data.

It is advantageous when time $T_1$ projection of time $T_1$ is determined when swept speeds of recorded signals are equal while swept directions are opposite.

It is furthermore advantageous when time $T_1$ projection of time $T_1$ is determined when swept speeds of recorded signals are different while swept directions are opposite.

Moreover, it is advantageous when time $T_1$ projection of time $T_1$ is determined when swept speeds of recorded signals are different while the swept direction is the same.

The essence of the system, according to the present invention, is that a source of radio frequency signals is connected to an input of a bridge whose output is connected to a computer while its input/output is connected to an input/output of a resonator, whereas one of the computer's outputs is connected to a wave shape generator which is connected to swept coils and the computer's other output is connected to power supply terminals of permanent magnetic field coils and gradient coils.

It is advantageous when an additional resonator is connected unidirectionally to the other input of the bridge.

The method outlined herein eliminates conventional techniques based on time-consuming spectral-spatial imaging and rotating gradient. The method enables an unambiguous determination of metabolic parameters in the biological object examined based on the fact that relaxation times $T_1$ and $T_2$ depend on oxygen concentration in the radical's environment.

The invention will be illustrated in greater detail on the basis of the example shown in figures, whereby Fig. 1 presents graphs of magnetization in equilibrium and actual magnetization in the second field swept period, Fig. 2 - a system for implementation in the block form, while Fig. 3 - a variant of the system with two resonators.

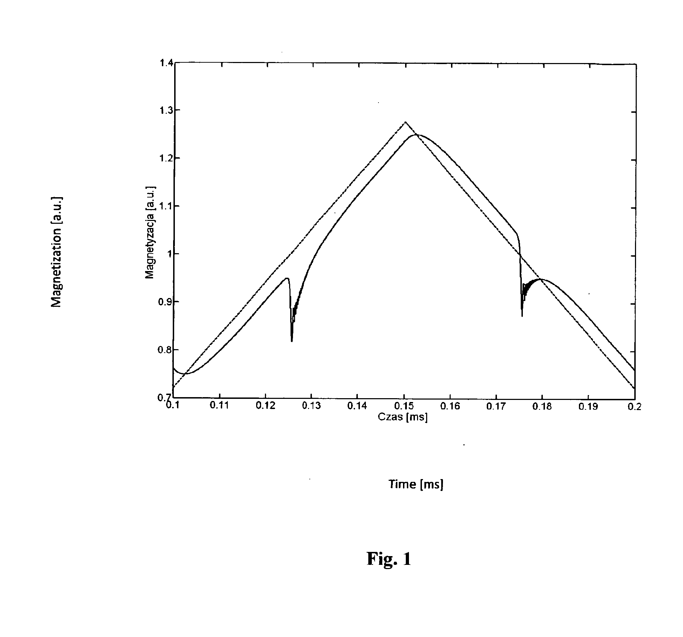

A test sample is placed in a magnetic field constituted by: a constant external magnetic field, either linearly or nonlinearly variable a gradient field and a swept magnetic field with a sinusoidal or triangular pattern, changing over the period T. Until time T/2, the swept field increases, thus increasing sample magnetization, with the first EPR signal being recorded at a specific moment determined by the resonance condition. After time T/2, the swept field decreases until time T. Over this period, magnetization becomes reduced and the second EPR signal is recorded. Owing to spin-lattice relaxation processes, magnetization during the first passage through the resonance condition differs from that recorded during the second passage. Fig. 1 shows a graph of magnetization in equilibrium (dashed black line) and actual magnetization (continuous black line) of the sample for the swept frequency of 10 kHz, amplitude of 50 G and relaxation time $T_1$ of 3.4 $\mu$s. For reasons of simplicity, plot was simulated for the second swept period and magnetization change during resonance was marked. Magnetization in equilibrium for triangular-swept changes according to formula (1a):

$$(1a)\quad M_o = \begin{cases} M_o' + x\dfrac{2B_m}{T}\left(t - \dfrac{T}{4}\right) & 0 \le t < \dfrac{T}{2} \\[2ex] M_o' + x\dfrac{2B_m}{T}\left(\dfrac{3T}{4} - t\right) & \dfrac{T}{2} \le t < T \end{cases}$$

Whereas, magnetization in equilibrium for sinusoidal-swept changes according to formula (1b):

$$(1b)\quad M_o = M_o' + xB_m\sin(2\pi ft)$$

where $M_o'$ represents magnetization of the sample in the absence of the swept field, T - swept period, f - swept frequency, x - coefficient denoting magnetization per magnetic field unit and $B_m$ - amplitude of the swept field expressed in gausses.

If the rate of changes of the magnetic field in resonance conditions for the first signal is $b_1$, and for the second signal - $b_2$, calculating the ratio of amplitudes between the second and first signals makes it possible to definitely establish the distribution of spin-lattice relaxation time in the direction of the applied gradient, according to the following formula (2):

$$(2) \quad S = \frac{A_D}{A_G} = x \frac{B_o + b_2 T_1}{B_o \pm b_1 T_1}$$

where $B_o$ represents resonance field; $b_1$ - swept speed during the recording of the first signal; $b_2$ - swept speed during the recording of the second signal, $T_1$ - spin-lattice relaxation time, positive value of the $\pm$ symbol means that swept during signal recording is performed in the same direction, while negative value means that swept directions are opposite; parameter x=1 for source frequency equal to the resonance frequency of the resonator containing the sample, as long as an interval of time t between the registering signals fulfils a condition: $t \geq 6T_1$. Parameter x≠1 suits the varying frequencies or a condition: $t < 6T_1$. Coefficient S (formula 2) depends in a simple manner on relaxation time $T_1$ which can be easily determined from the above equation. Coefficient S is increases along with increasing speed of magnetic field swept. In order to accurately define relaxation time $T_1$, during researching of the registered signals with the opposite swept directions, the period of magnetic field swept must satisfy the condition: $T \geq 16T_1$. Whereas, during researching of the signals which were registered in the same swept direction, a period of magnetic field swept ought to fulfill condition: $T \geq 6T_1$.

A sample is placed in the resonator located within the permanent external magnetic field and a specified orientation of the magnetic field gradient. After activating the wave shape generator producing a variable magnetic field within the sample area, it is possible to detect EPR signal in the bridge which records both absorption and dispersion signals. Recorded EPR absorption and dispersion spectrum has oscillations resulting from passing the resonance line in a time comparable to, or shorter than, time $T_2$. To obtain a traditional absorption and dispersion spectrum, it is necessary to deconvolute data. The deconvolution procedure consists of finding a function from the formula (3):

$$(3) \quad X(\omega) = \frac{RS(\omega)}{A(\omega)}$$

where $RS(\omega)$ stands for the Fourier transform of the RS spectrum while $A(\omega)$ is a filter factor which equals $\exp(-i\omega^2/2b)$ for triangular swept. Then, application of the reverse Fourier transform of the $X(\omega)$ spectrum gives the standard form of the absorption and dispersion spectrum.

After identifying, in a known procedure, the EPR signal, measurement of coefficient S is performed in the presence of gradient and, on its basis, relaxation time $T_1$ (formula 2) is measured for each magnetic field value where the EPR signal has been recorded; S = 0 for those sample areas where no ERP signal has been identified. In this way, the distribution (projection) of relaxation time $T_1$ values is obtained after a single spectrum measurement. In the next stage, the procedure is repeated for a different orientation of the magnetic field gradient until measurements are complete. Time $T_1$ projections thus obtained are used to reconstruct, in a known procedure, an image of $T_1$ distribution, which directly translates into information about oxygen concentration in the object under examination. It is important that coefficient S can be measured by different means: on the basis of the absorption or dispersion spectrum. Furthermore, each of the spectra may exist in two forms: signal before and after data deconvolution, representing a processed signal and a traditional signal with typical oscillations for RS EPR spectra. It is distinctive that the value of parameter S measured from spectra which are not subject to data deconvolution is doubled, which means it must be divided by two in order to represent the correct value of the spin-spin relaxation time. If all variants are used, it is possible to obtain four values of parameter S (two for the absorption and two for the dispersion spectra) for each magnetic field value, which increases the signal-to-noise ratio by $\sqrt{2}$.

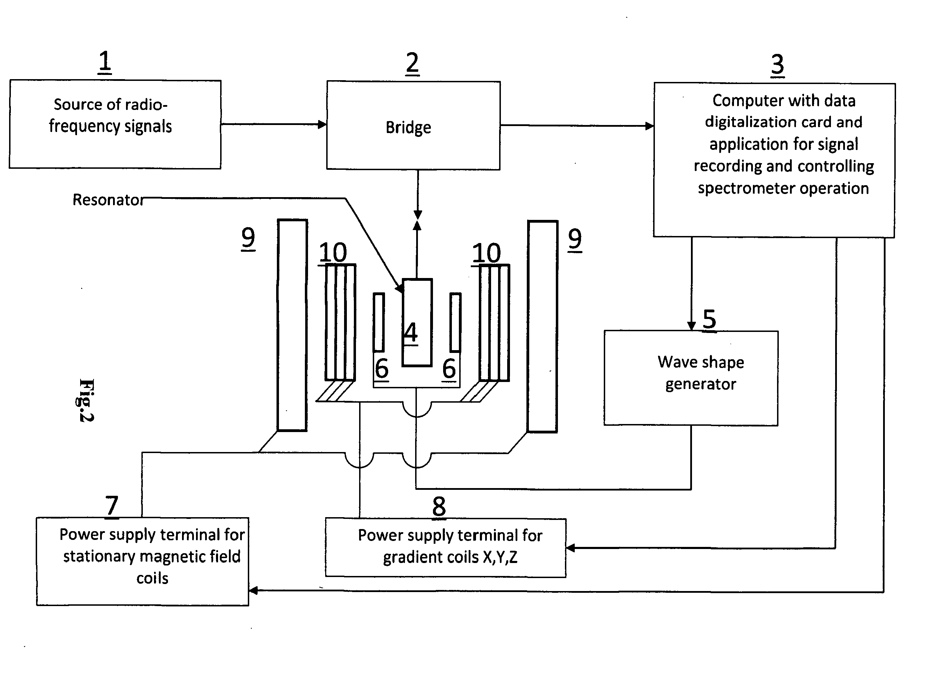

In the system for implementation of the method, according to the present invention, a source of radio-frequency signals 1 is connected to an input of a bridge 2 whose output is connected to a computer 3 while its input/output is connected to an input/output of a resonator 4, whereas one of the outputs of the computer 3 is connected to a wave shape generator 5 which is connected to swept coils 6 and the other output of the computer 3 is connected to power supply terminals 7 and 8 of permanent magnetic field coils 9 and gradient coils 10 (Fig. 2).

After placing a sample in the resonator 4 located between the pole pieces of an electromagnet (9), the wave shape generator 5 is activated to produce a variable magnetic field with a preset shape by means of coils 6. Afterwards, a radio-frequency signal emitted by the signal source 1, via the signal detection bridge 2, is transmitted to the resonator 4. After being sent, the signal returns to the signal detection bridge 2 which transmits the separated analogue absorption and dispersion signal to the computer 3 equipped with a data digitalization card. At this stage, usual preparatory operations are performed to identify resonance conditions using a standard SWR (Standing Wave Ratio) meter. Then, using gradient coils 10, the magnetic field gradient is connected, whose orientation determines the time of EPR signal recording from the initiation of swept. In addition to signal detection, the computer 3 also controls the course of the experiment, in particular: wave shape generator 5, power supply terminals for permanent magnetic field coils 7 and gradient field coils 8.

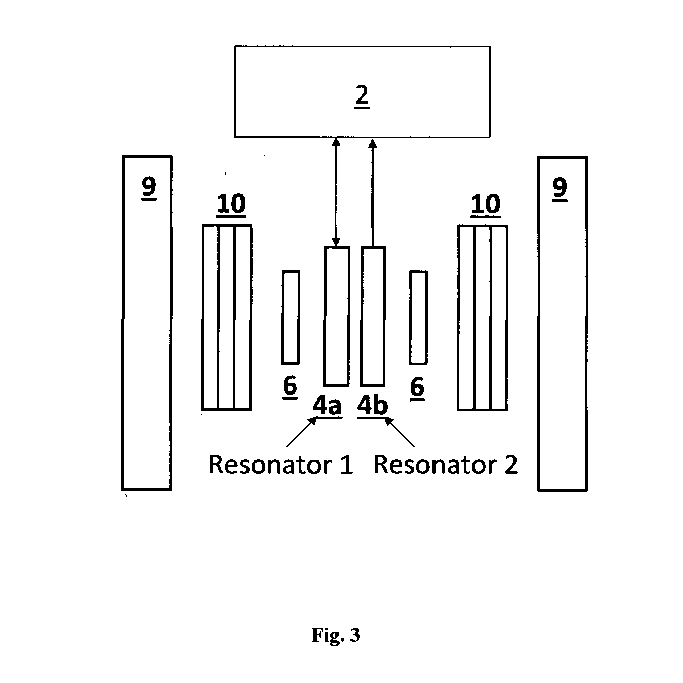

In addition to the signal detection method described above, its modified form in the system illustrated in Fig. 3 can also be used. The signal detection bridge 2 is equipped with an additional input for connecting another resonator 4b. In this case, after placing a sample in the resonator 4a located between the pole pieces of an electromagnet (9), the wave shape generator 5 is activated to produce a variable magnetic field with a preset shape by means of coils 6. Afterwards, the radio-frequency signal is transmitted to the resonator 4b. Consequently, the signal returns to the signal detection bridge 2 both from the resonator 4a and resonator 4b. In this case, the analogue absorption and dispersion signal is transmitted to the computer 3 from the bridge 2 using resonator 4a or 4b. At this stage, usual preparatory operations are performed to identify resonance conditions using a standard SWR (Standing Wave Ratio) meter in both resonators: 4a and 4b. Then, using coils 10, the magnetic field gradient is connected, whose orientation determines the time of EPR signal recording from the initiation of swept.

Calculation of the $A_D/A_G$ amplitude ratio (formula 2) of two EPR signals recorded in the presence of the magnetic field gradient directly from the RS spectrum or after deconvolution makes it possible to establish the projection of relaxation time $T_1$ of the test sample. To reconstruct a 2D image of oxygen concentration, no fewer than 18 projections should be made, i.e. spectra recorded at a constant gradient value but different orientation, which - assuming the swept frequency of 15 kHz - is at least 67 $\mu$s per each of them. Signal accumulation should be employed for practical reasons, however even if it is used, the duration is around 7 ms. The total time of measurement for all projections with specialist gradient coils should be 0.2 s. For the acquisition of a full 3D image, the time is around 2 s. The result shows that the technique described herein is the fastest known ERP imaging method, whereby it should also be noted that a significant portion of measurement time is devoted to the reorientation of the field gradient, not to the measurement itself. By using smaller gradients, and also slow-rotating gradients with assigned rotation, the time can be markedly reduced, thus speeding up measurement. Thanks to such short measurement times, it is possible to combine individual images into a sequence of frames presenting in real time changes in oxygen concentration in a selected tissue, which can substantially expand the knowledge of processes occurring e.g. during radiation therapy in oncology. The resolution power of images obtained in the technology depends on the gradient applied and on the sampling frequency. Using special filtration techniques, the resolution of images can equal ca. 0.5 mm, which is sufficient for precise measurements.

## Claims

1. Method for localization of cancerous and atheromatous lesions by EPRI, based on the measurement of the distribution of spin-lattice relaxation times of electron spins in a single projection, **characterized in that** the application of multi-component magnetic field to a sample placed in the resonator makes it possible to establish a ratio or any other combination of EPR signal amplitudes recorded in swept conditions, in the presence of a magnetic field gradient, thus obtaining a projection image of relaxation time $T_1$.

2. The method according to claim 1, **characterized in that** the multi-component magnetic field is constituted by a constant external magnetic field, a gradient field and a swept magnetic field (with a sinusoidal or triangular pattern), changing over time T.

3. The method according to claim 2, **characterized in that** the EPR signal amplitude ratio is established at the frequency of source equal to the resonance frequency of the resonator.

4. The method according to claim 2, **characterized in that** the EPR signal amplitude ratio is established at the frequency of source different from the resonance frequency of the resonator.

5. The method according to claim 1 or 2 or 3 or 4, **characterized in that** the EPR signal, defined as the spectrum absorption signal, is obtained by the RS EPR method.

6. The method according to claim 1 or 2 or 3 or 4, **characterized in that** the EPR signal, defined as the spectrum dispersion signal, is obtained by the RS EPR method.

**7.** The method according to claim 1 or 2 or 3 or 4, **characterized in that** the EPR signal, defined as the spectrum absorption signal, is obtained after data deconvolution.

**8.** The method according to claim 1 or 2 or 3 or 4, **characterized in that** the EPR signal, defined as the spectrum dispersion signal, is obtained after data deconvolution.

**9.** The method according to claim 1 or 2 or 3 or 4, **characterized in that** a $T_1$ time projection is determined when swept speeds of signals being recorded are equal while swept directions are opposite.

**10.** The method according to claim 1 or 2 or 3 or 4, **characterized in that** a $T_1$ time projection is determined when swept speeds of signals being recorded are different while swept directions are opposite.

**11.** The method of Claim 1 or 2 or 3 or 4, **characterized in that** a $T_1$ projection is determined when swept speeds of signals being recorded are different while swept directions are the same.

**12.** A system for localization of cancerous and atheromatous lesions by EPRI comprising a signal source; at least one resonator; a bridge; swept field, external field and gradient field coils together with power supply terminals; and a detection and control system, **characterized in that** a source of radio-frequency signals ($\underline{1}$) is connected to an input of a signal detection bridge ($\underline{2}$) whose input/output is bidirectionally connected to a resonator ($\underline{4}$, $\underline{4a}$), while an output of the signal detection bridge ($\underline{2}$) is connected to a computer ($\underline{3}$) whereas one of the computer's ($\underline{3}$) outputs is connected to a wave shape generator ($\underline{5}$) which is connected to swept coils ($\underline{6}$) and the computer's ($\underline{3}$) other output is connected to power supply terminals ($\underline{7}$) and ($\underline{8}$) of permanent magnetic field coils ($\underline{9}$) and gradient coils ($\underline{10}$).

**13.** The system according to claim 12, **characterized in that** an additional resonator ($\underline{4b}$) is unidirectionally connected to the other input of the bridge ($\underline{2}$).

Fig. 1

<u>3</u>
Computer with data digitalization card and application for signal recording and controlling spectrometer operation

<u>1</u>
Source of radio-frequency signals

<u>2</u>
Bridge

Resonator

<u>9</u>

<u>10</u>

<u>6</u>

<u>4</u>

<u>6</u>

<u>10</u>

<u>9</u>

<u>5</u>
Wave shape generator

<u>8</u>
Power supply terminal for gradient coils X,Y,Z

<u>7</u>
Power supply terminal for stationary magnetic field coils

**Fig.2**

8

**2**

**9**

**10**

**6**

**4a** **4b**

**6**

**10**

**9**

Resonator 1  Resonator 2

**Fig. 3**

Europäisches
Patentamt

European
Patent Office

Office européen
des brevets

# EUROPEAN SEARCH REPORT

Application Number

EP 10 00 0861

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2008/091365 A2 (US GOVERNMENT [US]; SUBRAMANIAN SANKARAN [US]; DEVASAHAYAM NALLATHAMBY) 31 July 2008 (2008-07-31) | 12 | INV.<br>G01N24/10<br>G01R33/60 |
| A | * paragraph [0044] - paragraph [0051]; figure 7 * | 1-11,13 | |
| X | OIKAWA K ET AL: "A 3D- and 4D-ESR Imaging System for Small Animals"<br>APPLIED RADIATION AND ISOTOPES, ELSEVIER, OXFORD, GB LNKD-<br>DOI:10.1016/S0969-8043(96)00167-4,<br>vol. 47, no. 11-12,<br>1 November 1996 (1996-11-01), pages 1605-1609, XP004220942<br>ISSN: 0969-8043<br>* page 1605, right-hand column - page 1607, left-hand column, paragraph 1 * | 12 | |
| X,D | JOSHI J P ET AL: "Rapid-scan EPR with triangular scans and fourier deconvolution to recover the slow-scan spectrum"<br>JOURNAL OF MAGNETIC RESONANCE, ACADEMIC PRESS, ORLANDO, FL, US LNKD-<br>DOI:10.1016/J.JMR.2005.03.013,<br>vol. 175, no. 1, 1 July 2005 (2005-07-01), pages 44-51, XP004929524<br>ISSN: 1090-7807 | 12 | |
| A | * the whole document * | 1-11,13 | |
| X | JP 2005 221477 A (JEOL LTD) 18 August 2005 (2005-08-18) | 12 | |
| A | * abstract; figures 1-4 * | 1-11,13 | |

**TECHNICAL FIELDS SEARCHED (IPC)**

G01N
G01R

-/--

The present search report has been drawn up for all claims

| Place of search | Date of completion of the search | Examiner |
|---|---|---|
| Munich | 5 May 2010 | Skalla, Jörg |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

& : member of the same patent family, corresponding
      document

EPO FORM 1503 03.82 (P04C01)

Europäisches
Patentamt
European
Patent Office
Office européen
des brevets

# EUROPEAN SEARCH REPORT

Application Number

EP 10 00 0861

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SUBRAMANIAN S ET AL: "Radio frequency continuous-wave and time-domain EPR imaging and Overhauser-enhanced magnetic resonance imaging of small animals: instrumental developments and comparison of relative merits for functional imaging" NMR IN BIOMEDICINE WILEY UK LNKD-DOI:10.1002/NBM.897, vol. 17, no. 5, August 2004 (2004-08), pages 263-294, XP002581070 ISSN: 0952-3480 | 12 | |
| A | * page 265, left-hand column, paragraph 2 * <br> * page 267, left-hand column, paragraph 3 - page 268, paragraph 1 * <br> * page 282 * <br> * page 285, right-hand column - page 287 * <br> ----- | 1 | |
| X | SATO-AKABA H ET AL: "Development and testing of a CW-EPR apparatus for imaging of short-lifetime nitroxyl radicals in mouse head" JOURNAL OF MAGNETIC RESONANCE, ACADEMIC PRESS, ORLANDO, FL, US LNKD-DOI:10.1016/J.JMR.2008.04.035, vol. 193, no. 2, 1 August 2008 (2008-08-01), pages 191-198, XP023177067 ISSN: 1090-7807 [retrieved on 2008-04-29] | 12 | TECHNICAL FIELDS SEARCHED (IPC) |
| A | * chapter 2 * <br> ----- <br> -/-- | 1 | |

The present search report has been drawn up for all claims

| Place of search | Date of completion of the search | Examiner |
|---|---|---|
| Munich | 5 May 2010 | Skalla, Jörg |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons

& : member of the same patent family, corresponding
 document

EPO FORM 1503 03.82 (P04C01)

EP 2 214 004 A1

Europäisches
Patentamt
European
Patent Office
Office européen
des brevets

**EUROPEAN SEARCH REPORT**

Application Number

EP 10 00 0861

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | STONER J W ET AL: "Direct-detected rapid-scan EPR at 250 MHz" JOURNAL OF MAGNETIC RESONANCE ACADEMIC PRESS USA LNKD-DOI:10.1016/J.JMR.2004.06.008, vol. 170, no. 1, September 2004 (2004-09), pages 127-135, XP002580966 ISSN: 1090-7807 * chapters 1 and 2 * | 1-13 | |
| A | PANAGIOTELIS I ET AL: "T1e* and T2e* maps derived in vivo from the rat using longitudinally detected electron spin resonance phase imaging: application to abdominal oxygen mapping" MAGNETIC RESONANCE IN MEDICINE WILEY USA, vol. 46, no. 6, December 2001 (2001-12), pages 1223-1232, XP002581071 ISSN: 0740-3194 * page 1223 - page 1224, left-hand column, paragraph 1; figure 5 * | 1 | TECHNICAL FIELDS SEARCHED (IPC) |

The present search report has been drawn up for all claims

| Place of search | Date of completion of the search | Examiner |
|---|---|---|
| Munich | 5 May 2010 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 10 00 0861

This annex lists the patent family members relating to the patent documents cited in the above-mentioned European search report.
The members are as contained in the European Patent Office EDP file on
The European Patent Office is in no way liable for these particulars which are merely given for the purpose of information.

05-05-2010

| Patent document cited in search report | | Publication date | Patent family member(s) | Publication date |
|---|---|---|---|---|
| WO 2008091365 | A2 | 31-07-2008 | NONE | |
| JP 2005221477 | A | 18-08-2005 | NONE | |

EPO FORM P0459

For more details about this annex : see Official Journal of the European Patent Office, No. 12/82